# EUROPEAN PATENT APPLICATION

(11) **EP 3 678 266 A1**
(43) Date of publication of application: **08.07.2020**
(21) Application number: 18850345.2
(22) Date of filing: 25.07.2018
(51) Int. Cl.: H01S 5/02, C09K 11/08, C09K 11/79, C09K 11/80, G02B 5/20, H01L 33/50

(54) **LIGHT EMITTING DEVICE**

(30) Priority: 28.08.2017 JP 2017163575
(71) Applicant: Panasonic Intellectual Property Management Co., Ltd., Osaka-shi, Osaka 540-6207 (JP)
(72) Inventor: ABE Takeshi, Osaka-shi, Osaka 540-6207 (JP); OSHIO Shozo, Osaka-shi, Osaka 540-6207 (JP)
(74) Representative: Müller-Boré & Partner Patentanwälte PartG mbB
(86) International application number: PCT/JP2018/027810
(87) International publication number: WO 2019/044288

(57) **Abstract**

A light emitting device includes: a solid-state light emitting element that emits excitation light having a maximum intensity value within a wavelength range of 440 nm or more and less than 470 nm; and a wavelength conversion member composed by combining a first wavelength converter, which includes a first phosphor activated by Ce³⁺, and a second wavelength converter, which includes a second phosphor activated by Ce³⁺, with each other. The first phosphor emits first fluorescence having a maximum intensity value within a wavelength range of 470 nm or more and less than 530 nm, and the second phosphor emits second fluorescence having a maximum intensity value within a wavelength range of 580 nm or more and less than 660 nm. The first wavelength converter has a dispersed state in which particles of the first phosphor are not in contact with one another.

## Description

### TECHNICAL FIELD

The present invention relates to a light emitting device composed by combining a phosphor and a solid-state light emitting element with each other. The solid-state light emitting element is particularly a laser diode.

### BACKGROUND ART

Heretofore, there has been known a light emitting device composed by combining a solid-state light emitting element and a wavelength converter including a phosphor with each other. As such a light emitting device as described above, for example, a white LED light source, a laser illuminator and a laser projector have been known.

In a light emitting device using laser light, a Ce³⁺-activated phosphor that emits fluorescence with ultrashort afterglow properties is preferably used in order to relieve saturation of a light output, which follows an increase of a power density of light that excites a phosphor. Then, at least a Ce³⁺-activated phosphor that emits green-series (blue-green or green) fluorescence and a Ce³⁺-activated phosphor that emits warm color-series (orange or red) fluorescence are used in combination, whereby illumination light with high color rendering properties can be achieved (for example, refer to PTL 1).

### CITATION LIST

### PATENT LITERATURE

Patent Literature 1: International Publication No. WO 2016/092743

### SUMMARY OF INVENTION

### TECHNICAL PROBLEM

However, in general, the warm color-series Ce³⁺-activated phosphor has characteristics of absorbing blue to blue-green light components well. Hence, in a case of adopting a device structure in which the warm color-series phosphor and the green-series phosphor are close to each other, there has been a problem that a short wavelength-side (blue to blue-green) light component of green-series light emitted by the green-series phosphor is absorbed by the warm color-series phosphor to decrease an intensity thereof, resulting in a decrease in color rendering properties of output light.

The present disclosure has been made in consideration of such a problem as described above, which is inherent in the prior art. It is an object of the present disclosure to provide a light emitting device including a plurality of types of Ce³⁺-activated phosphors different in color tone and an excitation source, wherein, even in the case of adopting the device structure in which the warm color-series phosphor and the green-series phosphor are close to each other, a light component intensity of blue-green light is relatively large and color rendering properties of output light are high.

### SOLUTION TO PROBLEM

In order to solve the above-described problem, a light emitting device according to an aspect of the present disclosure includes: a solid-state light emitting element that emits excitation light having a maximum intensity value within a wavelength range of 440 nm or more and less than 470 nm; and a wavelength conversion member composed by combining a first wavelength converter, which includes a first phosphor that is a particulate phosphor and is an inorganic phosphor activated by Ce³⁺, and a second wavelength converter, which includes a second phosphor that is an inorganic phosphor activated by Ce³⁺, with each other. The first phosphor emits first fluorescence having a maximum intensity value within a wavelength range of 470 nm or more and less than 530 nm, and the second phosphor emits second fluorescence having a maximum intensity value within a wavelength range of 580 nm or more and less than 660 nm. The first wavelength converter has a dispersed state in which particles of the first phosphor are not in contact with one another.

### BRIEF DESCRIPTION OF DRAWINGS

FIG. 1 is a schematic diagram of an example of a light emitting device according to an embodiment of the present disclosure.
FIG. 2 is a schematic diagram of an example of the light emitting device according to the embodiment of the present disclosure.
FIG. 3 is a schematic diagram of an example of the light emitting device according to the embodiment of the present disclosure.
FIG. 4 is a top view of a first wavelength converter.
FIG. 5 is electron micrographs of phosphors according to Example.
FIG. 6 is a diagram illustrating a fluorescence spectrum (a) of a first wavelength converter according to Example and a fluorescence spectrum (b) of a first phosphor (powder compact).
FIG. 7 is a diagram illustrating an excitation spectrum (a) that represents wavelength dependency of a light absorption rate in a second phosphor according to Example, a fluorescence spectrum (b) of the first phosphor, and a fluorescence spectrum (c) of the second phosphor.
FIG. 8 is a diagram illustrating fluorescence spectra (a) of wavelength conversion members according to seven types of Examples in each of which a dispersed state of the first phosphor is changed, the fluorescence spectrum (b) of the first phosphor, and the fluorescence spectrum (c) of the second phosphor.
FIG. 9 is a diagram illustrating fluorescence spectra (a) of wavelength conversion members according to five types of Comparative examples created as powder compacts formed by mixing particles of first and second phosphors with each other in ratios different from one another, the fluorescence spectrum (b) of the first phosphor, and the fluorescence spectrum (c) of the second phosphor.
FIG. 10 is spectral distributions of white light located on a blackbody locus, the white light being obtained by additive color mixture of fluorescences emitted by respective wavelength conversion members in Examples same as those in FIG. 8 and blue laser light with a wavelength of 455 nm.
FIG. 11 is spectral distributions of white light located on a blackbody locus, the white light being obtained by additive color mixture of fluorescences emitted by respective wavelength conversion members in Comparative examples same as those in FIG. 9 and blue laser light with a wavelength of 455 nm.

### DESCRIPTION OF EMBODIMENTS

This embodiment will be described below with reference to the drawings. Note that any of embodiments to be described below illustrates a preferable specific example of this embodiment. Hence, numeric values, shapes, materials, constituents, arrangement positions and connection modes of the constituents, and the like, which are illustrated in the following embodiment, are merely examples, and are not intended to limit this embodiment. Hence, among the constituents in the embodiments to be described below, constituents which are not described in the independent claims showing the top-level concept of this embodiment are described as arbitrary constituents.

Note that the respective diagrams are schematic diagrams, and are not always strictly illustrated. Moreover, in the respective drawings, the same reference numerals are assigned to substantially the same constituents, and duplicate descriptions will be omitted or simplified. Note that, in this description, "Ce³⁺-activated phosphor" is simply referred to as "phosphor" in some cases.

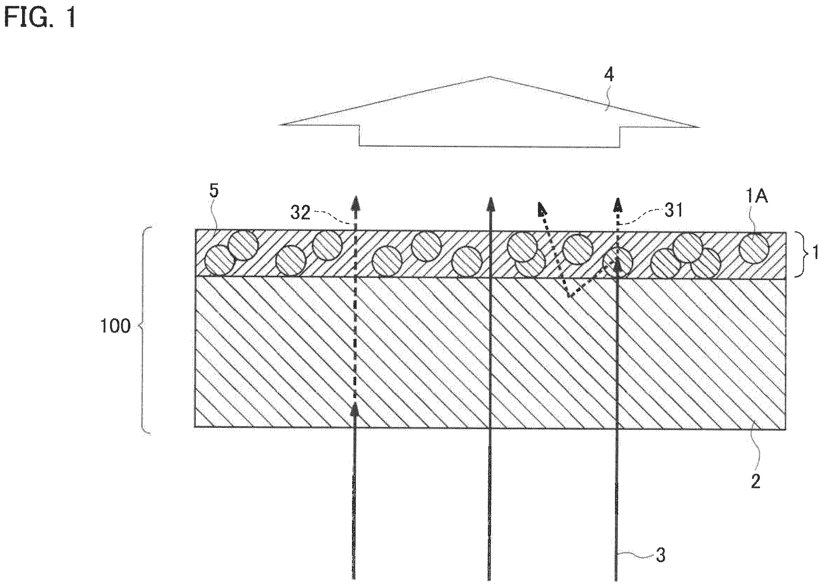

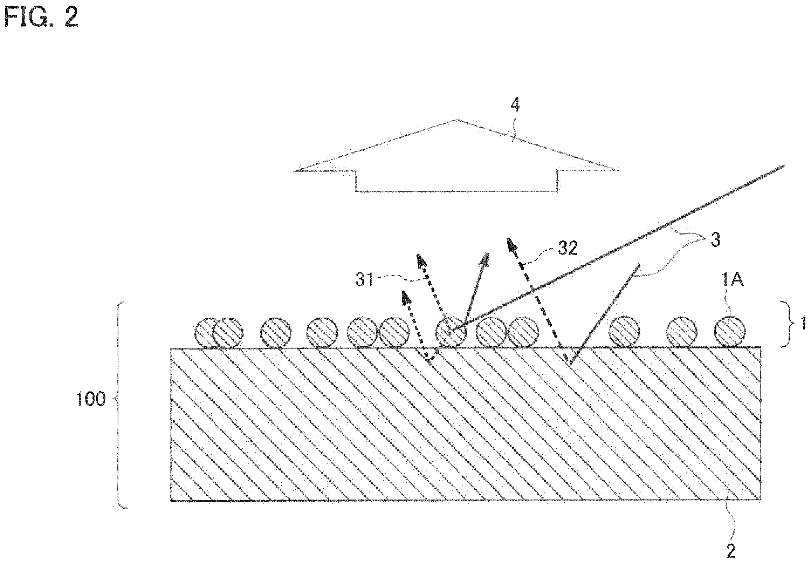

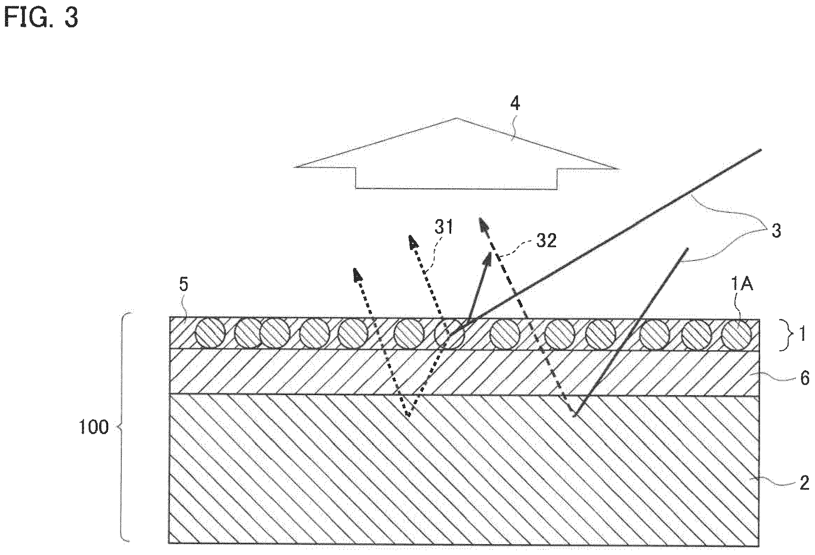

First, a description will be given of a configuration of a light emitting device according to this embodiment with reference to FIGS. 1 to 3. FIG. 1 is a schematic diagram of a light emitting device having a structure called a transmissive structure, and FIG. 2 and FIG. 3 are schematic diagrams of light emitting devices having structures called reflective structures. As illustrated in FIG. 1, the transmissive light emitting device includes a wavelength conversion member 100 in which a first wavelength converter 1 and a second wavelength converter 2 are stacked on each other, and has a feature that excitation light 3 for exciting phosphors is output in such a direction of transmitting through the wavelength conversion member 100. Then, the excitation light 3 enters the wavelength conversion member 100 so as to directly irradiate the second wavelength converter 2, and a light component that transmits through the wavelength conversion member 100 is output as output light 4.

When such a transmissive light emitting device is adopted, it becomes easy to suppress an intensity of a light component of the excitation light 3 by increasing a thickness of the wavelength conversion member 100. Hence, even if the excitation light 3 is light having a spectral distribution concentrated on a specific wavelength component, for example, laser light, a light emitting device that easily turns the output light 4 to white light with a low color temperature is formed. Moreover, there decreases a probability at which a blue-green light component of fluorescence emitted by the first wavelength converter 1 is absorbed by the second wavelength converter 2, and accordingly, the fluorescence emitted by the first wavelength converter 1 holds an original fluorescence spectrum shape, and a light emitting device that easily turns the output light 4 to white light with high color rendering properties is formed.

Meanwhile, as illustrated in FIG. 2 and FIG. 3, each of the reflective light emitting devices includes a wavelength conversion member 100 in which the first wavelength converter 1 and the second wavelength converter 2 are stacked on each other, and has a feature that the excitation light 3 is output in such a direction of being reflected by the wavelength conversion member 100. Then, the excitation light 3 enters the wavelength conversion member 100 so as to directly irradiate the first wavelength converter 1, and a light component reflected by the wavelength conversion member 100 is output as the output light 4.

When such a reflective light emitting device is adopted, it is possible to adopt a device structure in which heat dissipation design of the second wavelength converter 2 is easy, and accordingly, such a light emitting device is formed, which is capable of selecting a phosphor in which temperature quenching is relatively large as the second phosphor. Moreover, it is possible to adopt a device structure in which a light output surface that emits the output light 4 serves as the first wavelength converter 1, and accordingly, an appearance of the light output surface exhibits a color close to a body color of the first wavelength converter 1, and becomes relatively inconspicuous. Furthermore, there decreases the probability at which the blue-green light component of the fluorescence emitted by the first wavelength converter 1 is absorbed by the second wavelength converter 2, and accordingly, the fluorescence emitted by the first wavelength converter 1 easily holds an original fluorescence spectrum shape, and it is easy to turn the output light 4 to such white light with high color rendering properties.

In FIGS. 1 to 3, the first wavelength converter 1 is a wavelength converter including at least a Ce³⁺-activated phosphor as a first phosphor 1A that emits first fluorescence 31. The first wavelength converter 1 is composed by including a Ce³⁺-activated phosphor (first phosphor 1A) that emits first fluorescence having a fluorescence peak, for example, within a wavelength range of 470 nm or more and less than 530 nm, preferably 480 nm or more and less than 515 nm.

As illustrated in FIG. 1 and FIG. 3, the first wavelength converter 1 can be created by sealing the first phosphor 1A by a sealing material 5. The sealing material can be at least one of an organic material and an inorganic material, and particularly, at least one of a transparent (translucent) organic material and a transparent (translucent) inorganic material. As such a sealing material made of the organic material, for example, a transparent organic material such as a silicon resin is mentioned. As such a sealing material made of the inorganic material, for example, a transparent inorganic material such as low-melting-point glass is mentioned.

The first wavelength converter 1 can also be created by bonding particles of the first phosphor 1A to the second wavelength converter 2 as illustrated in FIG. 2, or by bonding the particles of the first phosphor 1A to a translucent member 6, which is provided on the second wavelength converter 2, as illustrated in FIG. 3. For the bonding, at least one of an organic binding agent and an inorganic binding agent can be used. As an example of the binding agents, there are mentioned a resin-series adhesive used commonly, and ceramic fine particles, low-melting-point glass and the like.

In this embodiment, the first phosphor 1A is particulate. In this embodiment, an average particle size of the particulate phosphor is preferably 3 µm or more, more preferably 5 µm or more, particularly preferably 10 µm or more. The average particle size of the phosphor particles is preferably less than 50 µm, more preferably less than 30 µm. These phosphor particles can be powdery when viewed macroscopically. Herein, the average particle size refers to an average value of maximum axial lengths of particles when a particle group of the phosphor is observed by a microscope.

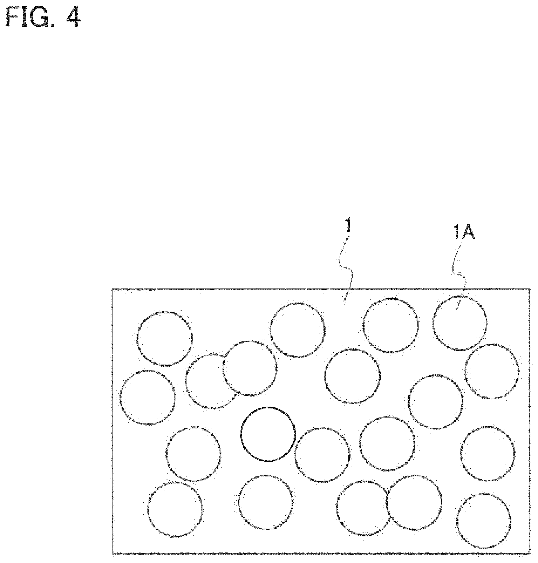

The light emitting device of this embodiment is characterized in that, as illustrated in FIGS. 1 to 3, the first wavelength converter 1 has a dispersed state in which the particles of the first phosphor 1A are not in contact with one another. In this dispersed state, a ratio of an area of the particles of the first phosphor 1A with respect to an area of the first wavelength converter on a top view (FIG. 4) of the first wavelength converter is less than 90%, preferably less than 80%, more preferably less than 50%. In this dispersed state, among all the particles of the first phosphor 1A in the first wavelength converter 1, a ratio of the particles of the first phosphor 1A being in contact with other particles is less than 50%, preferably less than 30%, more preferably less than 10%, particularly preferably less than 1% or 0%. Then, when such a dispersed state is formed, an average inter-particle distance of the Ce³⁺-activated phosphor increases.

Herein, since the first phosphor 1A is a Ce³⁺-activated phosphor having a self-absorption effect to be described later, the self-absorption effect of the Ce³⁺-activated phosphor is relieved when the inter-particle distance is increased as described above. As a result, a fluorescence spectrum shifts to a short wavelength side as a whole, and functions to increase a blue-green light component intensity while keeping a composition of the phosphors. The blue-green light component has an effect of improving color rendering properties of white output light, and accordingly, a light emitting device that easily obtains the output light 4 with high color rendering properties is thereby formed.

Hereinafter, the self-absorption effect of the Ce³⁺-activated phosphor will be described. First, characteristics of the Ce³⁺-activated phosphor, which are required to understand the self-absorption effect, will be described.

The light absorption and fluorescence of the Ce³⁺-activated phosphor are respectively on the basis of electron energy transitions of 4f^{l}→5d^{l} and 5d^{l}→4f^{l} of Ce³⁺ ions, and specifically, 4fⁿ↔4fⁿ⁻¹5d^{l} transitions at time of n=1. That is, there are: a light absorption process in which one electron in a 4f shell in the Ce³⁺ ion is excited from the 4f shell to a 5d shell; and a fluorescence process in which one electron excited to the 5d shell is relieved from the 5d shell to the 4f shell. A direction of exciting in the fluorescence process is counter to that in the light absorption process. These electron energy transitions are parity-allowed/spin-allowed transitions defined in the quantum mechanics, and are electron energy transitions allowed in the nature, and accordingly, the light absorption and the fluorescence occur without difficulty.

Moreover, as a feature common to activators (Ce³⁺, Eu²⁺, Yb²⁺) which exhibit the light absorption and the fluorescence, which are caused by the above-described 4fⁿ↔4fⁿ⁻¹5d^{l} transitions, mentioned is the fact that a Stokes shift is so small that a long wavelength end of an excitation spectrum and a short wavelength end of the fluorescence spectrum overlap each other. The Stokes shift refers to an energy difference between the light absorption and the fluorescence, and corresponds to an energy conversion value of a wavelength difference between a light absorption peak and a fluorescence peak.

Note that the energy transition of Ce³⁺ and the feature thereof, which are as described above, are described in detail in handbooks and text books about rare earth phosphors, and are well-known to those skilled in the art.

Such characteristics are provided. Therefore, when crystal particles of the Ce³⁺-activated phosphor are brought close to one another, a short wavelength component of the fluorescence of a Ce³⁺-activated phosphor (hereinafter, Ce³⁺-activated phosphor A) is absorbed to a Ce³⁺-activated phosphor (hereinafter, Ce³⁺-activated phosphor B) close thereto and other than the same. As a result, the Ce³⁺-activated phosphor A emits fluorescence in which a light component intensity on the short wavelength side of the fluorescence spectrum decreases.

Meanwhile, the Ce³⁺-activated phosphor B that absorbs a light component on the short wavelength side in the fluorescence spectrum of the Ce³⁺-activated phosphor A converts light energy thereof into a long-wavelength fluorescent component having lower energy than the light component on the short wavelength side. As a result, the Ce³⁺-activated phosphor B emits fluorescence in which a light component intensity on the long wavelength side of the fluorescence spectrum relatively increases.

Then, when crystal particles of a plurality of the Ce³⁺-activated phosphors are brought close to each other, such effects as described above are averaged. Accordingly, the fluorescence spectrum shifts to the long wavelength side in comparison with a case where one crystal particle of the Ce³⁺-activated phosphor is isolated.

That is, even if phosphors are identical in terms of composition, particle size and the like, fluorescence spectra and/or fluorescence peak wavelengths change depending on a distance between the crystal particles of the phosphors and/or the number of particles close to one another, and the fluorescence spectrum and/or fluorescence peak wavelength shifts to the short wavelength side as the phosphor particles are dispersed more thinly.

In a general photoluminescence evaluation method of evaluating a fluorescence spectrum by applying excitation light to an aggregate of phosphor particles, the above matter means that, at least with regard to the Ce³⁺-activated phosphor, a spectrum that shifts to a relatively long wavelength side in comparison with that of a fluorescence spectrum of single particles is obtained.

This embodiment positively uses such a phenomenon recognized in the evaluation of the fluorescence spectrum of the Ce³⁺-activated phosphor. Specifically, the particles of the Ce³⁺-activated phosphor that emits the fluorescence having at least a blue-green light component are arranged thinly and used, whereby there is increased the intensity of the blue-green light component that contributes greatly to obtainment of the white light with high color rendering properties, and illumination with high color rendering properties is achieved.

Note that this embodiment exerts a particularly advantageous effect in a laser illumination technique using blue laser light and a phosphor. This results from the blue-green light component is regarded particularly important since usable fluorescence spectra are extremely limited in the blue laser light.

In FIGS. 1 to 3, the second wavelength converter 2 is a wavelength converter including at least a second phosphor 2A (not shown) that emits second fluorescence 32 different from the first fluorescence 31. The second wavelength converter 2 is a wavelength converter composed by including a Ce³⁺-activated phosphor that emits second fluorescence having a fluorescence peak, for example, within a wavelength range of 580 nm or more and less than 660 nm, preferably 590 nm or more and less than 640 nm, more preferably 595 nm or more and less than 620 nm. When such a second phosphor 2A is used, it becomes easy to obtain illumination light with high color rendering properties.

Then, such a wavelength converter can be created by sealing the second phosphor 2A by a sealing material made of an organic material or an inorganic material, or by forming the second phosphor 2A into a sintered body or ceramics.

Note that, in the light emitting device of this embodiment, the second phosphor 2A generally has light absorption characteristics of absorbing at least a part of a light component of the first fluorescence 31. Then, the second phosphor 2A tends to have light absorption characteristics of absorbing a large amount of the blue-green light component on the short wavelength side of the first fluorescence 31, and accordingly, it becomes important to devise to increase the blue-green light component intensity.

Therefore, a preferable mode is a device structure in which the wavelength conversion member 100 is formed into a two-layer structure of the first wavelength converter 1 and the second wavelength converter 2, then the excitation light 3 is applied to the second wavelength converter 2, and at least the excitation light 3 and the second fluorescence 32 transmit through the wavelength conversion member 100 (FIG. 1). This refers to a transmissive device structure. Moreover, a preferable mode is a device structure in which a similar two-layer structure is adopted, then the excitation light 3 is applied to the first wavelength converter 1, and at least the excitation light 3 and the first fluorescence 31 are reflected by the wavelength conversion member 100 (FIG. 2 and FIG. 3). This refers to a reflective device structure.

In such a structure, there is increased a ratio in which the first fluorescence 31 emitted by the first phosphor 1A is used as a light component of the output light 4 without being absorbed to the second phosphor 2A. Hence, a shape of the first fluorescence 31 becomes close to the fluorescence spectrum shape inherent in the first phosphor 1A, and a light emitting device that emits the output light 4 in which the ratio of the blue-green light component is large is formed.

In FIGS. 1 to 3, the excitation light 3 is light emitted by an excitation source (not shown), and is light that excites at least one of the first phosphor 1A included in the first wavelength converter 1 and the second phosphor 2A included in the second wavelength converter 2.

Note that, preferably, the excitation light 3 is blue light having a maximum intensity value within a wavelength range of 440 nm or more and less than 470 nm, preferably 445 nm or more and less than 465 nm, more preferably 450 nm or more and less than 460 nm. In this way, a semiconductor light emitting element that is high-power and relatively inexpensive, and particularly, a laser diode can be used as the excitation source.

Note that, in this embodiment, the preferable excitation light 3 is laser light. In this way, laser light that has a large light density and is excellent in directivity and/or convergence can be used as the excitation light of the first phosphor 1A and the second phosphor 2A or as the light component of the output light 4 of the light emitting device.

In FIGS. 1 to 3, the output light 4 is output light emitted by the light emitting device, and for example, is white light for use in illumination. The output light 4 can also be mixed-color light in which the respective light components are additively mixed with one another, the light components being: the excitation light 3; the first fluorescence 31 obtained by subjecting the excitation light 3 to wavelength conversion by the first phosphor 1A; and the second fluorescence 32 obtained by subjecting the excitation light 3 to wavelength conversion by the second phosphor 2A.

As seen from FIGS. 1 to 3, the light emitting device according to this embodiment includes a solid-state light emitting element (not shown) to be used as an excitation source, and the wavelength conversion member 100. Then, the wavelength conversion member 100 is composed by combining the first wavelength converter 1, which includes the first phosphor 1A that is a particulate phosphor and is an inorganic phosphor activated by Ce³⁺, and the second wavelength converter 2, which includes the second phosphor 2A that is an inorganic phosphor activated by Ce³⁺, with each other. Then, the solid-state light emitting element emits the excitation light 3 having the maximum intensity value within the wavelength range of 440 nm or more and less than 470 nm. Moreover, the first phosphor 1A emits the first fluorescence 31 having the maximum intensity value within the wavelength range of 470 nm or more and less than 530 nm, and the second phosphor 2A emits the second fluorescence 32 having the maximum intensity value within the wavelength range of 580 nm or more and less than 660 nm.

The light emitting device of this embodiment is the light emitting device having such a configuration, in which the first wavelength converter 1 has a dispersed state in which the particles of the first phosphor 1A are not in contact with one another. That is, the light emitting device is characterized in that the particles of the first phosphor 1A are arranged so as to be thin.

With such a structure, the inter-particle distance of the Ce³⁺-activated phosphor serving as the first phosphor 1A relatively increases, and accordingly, the above-described self-absorption effect of the Ce³⁺-activated phosphor is relieved, and the fluorescence spectrum shifts to the short wavelength as a whole. As a result, the intensity of the blue-green light component having the effect of improving the color rendering properties increases, and the light emitting device that easily makes the output light 4 into the white light with high color rendering properties is formed.

That is, in the light emitting device of this embodiment, the first phosphor 1A holds the dispersed state in which the particles are not in contact with one another, whereby the fluorescence peak shifts to the short wavelength side. In this embodiment, as described above, the fluorescence peak can be shifted to the short wavelength side without changing the composition of the first phosphor, and accordingly, the spectrum of the output light can be controlled by using the existing phosphor.

In a preferable example of the light emitting device of this embodiment, the second phosphor 2A can be a particulate phosphor, and the second wavelength converter 2 can have a contact structure in which particles of the second phosphor 2A are in contact with one another. In this contact structure, among all the particles of the second phosphor 2A in the second wavelength converter 2, a ratio of those in contact with other particles is 90% or more, preferably 95% or more, more preferably 99% or more, particularly preferably 99.9% or more or 100%. With this, the inter-particle distance of the Ce³⁺-activated phosphor decreases, and accordingly, the self-absorption effect of the Ce³⁺-activated phosphor enhances, and a ratio of the long-wavelength fluorescent component increases. Therefore, it becomes possible to increase an intensity of a red light component having the effect of improving the color rendering properties of the white output light, and particularly, an effect of improving a special color rendering index R9 thereof.

In another preferable example of the light emitting device of this embodiment, the second phosphor 2A is a sintered body or ceramics of a phosphor. The sintered body of the phosphor refers to one that is composed by sintering a phosphor and has a plurality of air gaps in an inside thereof. The ceramics of the phosphor refer to those which are composed by sintering a phosphor and do not have a plurality of air gaps in an inside thereof. The ceramics or sintered body of the Ce³⁺-activated phosphor originally has a structure in which the self-absorption effect of the Ce³⁺-activated phosphor is large, and accordingly, the ratio of the long-wavelength fluorescent component increases, and the intensity of the red light component having the effect of improving the color rendering properties of the white output light increases. Moreover, the ceramics or the sintered body is excellent in thermal conductivity, and accordingly, adoption of this leads to a light emitting device that easily achieves a temperature reduction of the wavelength converter by heat dissipation design.

Then, in the form in which the wavelength conversion member 100 is formed to have such a stacked structure of the first wavelength converter 1 and the second wavelength converter 2, a light emitting device is formed, in which the first fluorescence 31 easily holds the fluorescence spectrum shape original to the first phosphor, and in which it is easy to emit the output light 4 with a high-value Ra exceeding 80, preferably 85.

In this embodiment, the first fluorescence 31 can be set to fluorescence having a fluorescence peak within a wavelength range of 470 nm or more and less than 530 nm, preferably 480 nm or more and less than 515 nm, more preferably 490 nm or more and less than 510 nm. Moreover, the second fluorescence 32 can be set to one having a fluorescence peak within a wavelength range of 580 nm or more and less than 660 nm, preferably 590 nm or more and less than 640 nm, more preferably 595 nm or more and less than 620 nm. With this, a light emitting device is formed, which can emit at least a green-series (blue-green or green) fluorescent component and a warm color-series (orange or red) fluorescent component, which are required for illumination with high color rendering properties.

In a preferable example of this embodiment, the first phosphor 1A is at least one of aluminate and silicate. Moreover, the second phosphor 2A is at least one of silicate and aluminosilicate. Such phosphors are not only chemically stable but also easily available and producible, and accordingly, a light emitting device easy to manufacture is thereby formed.

In a preferable example of this embodiment, at least one of the first phosphor 1A and the second phosphor 2A can be set to a garnet phosphor having a garnet-type crystal structure, and both thereof can be set to garnet phosphors.

Then, in a particularly preferable example of this embodiment, the first phosphor 1A is aluminate having the garnet-type crystal structure. Moreover, the second phosphor 2A is silicate having the garnet-type crystal structure. Such garnet phosphors are not only chemically stable but also easily producible, and have high track records for use in solid-state illumination, and accordingly, a light emitting device easy to manufacture and excellent in long-term reliability is thereby formed.

A specific example of the preferable first phosphor 1A is a garnet phosphor, which is composed by containing, as a base, Lu₃(Al₁₋ₓGaₓ)₂(AlO₄)₃ that is an aluminate compound, in which x is a numeric value that satisfies 0 ≤ x ≤ 1, preferably 0.3 ≤ x ≤ 1, particularly preferably x = 1. The Ce³⁺-activated phosphor composed by containing Lu₃(Al₁₋ₓGaₓ)₂(AlO₄)₃ as a base emits fluorescence having a large quantity of the blue-green light component that greatly contributes to the enhancement of the color rendering properties of the illumination light. Hence, use of this leads to a light emitting device, which emits illumination light that has a relatively large quantity of the blue-green light component and is advantageous in terms of the color rendering properties.

"One composed by containing Lu₃(Al₁₋ₓGaₓ)₂(AlO₄)₃ as a base" refers to a solid solution in which a solid solution ratio of Lu₃(Al₁₋ₓGaₓ)₂(AlO₄)₃ is 70 mol% or more, and particularly 90 mol% or more, or refers to Lu₃(Al₁₋ₓGaₓ)₂(AlO₄)₃ as a compound.

Note that, as the first phosphor 1A other than the above-described aluminate phosphor, usable is a Ce³⁺-activated phosphor composed based on a compound containing, as a main component, at least one selected from the group consisting of an alkaline earth metal composite oxide having a calcium ferrite-type structure, alkaline earth metal halo-aluminate, rare earth aluminate, alkaline earth metal silicate, and rare earth oxynitride silicate.

Specifically, as the first phosphor 1A, usable is a Ce³⁺-activated phosphor composed based on a compound containing, as a main component, any compound selected from MRE₂O₄, M₃AlO₄F, M₂REX₂(AlO₄)₃, M₃RE₂(SiO₄)₃, RE₅(SiO₄)₃N, RE₄Si₂O₇N₂, RESiO₂N, RE₂Si₃O₃N₄, RE₅Si₃O₁₂N, and RE₃Si₈O₄N₁₁, or based on a solid solution containing any of these compounds as an end member. Herein, M is alkaline earth metal, RE is rare earth, X is at least one element selected from Zr and Hf, and x is a numeric value that satisfies 0 ≤ z < 1.

More specifically, as the first phosphor 1A, usable is a Ce³⁺-activated phosphor composed based on a compound containing, as a main component, any compound selected from SrLu₂O₄, SrSc₂O₄, Sr₃AlO₄F, Ca₂YZr₂(AlO₄)₃, Ca₃Sc₂(SiO₄)₃, Y₅(SiO₄)₃N, Y₄Si₂O₇N₂, Y₂Si₃O₃N₄, La₅Si₃O₁₂N, and La₃Si₈O₄N₁₁, or based on a solid solution containing any of these compounds as an end member, or the like.

Such a phosphor emits fluorescence having a fluorescence peak within a wavelength range of 470 nm or more and less than 530 nm, and 470 to 510 nm in a preferable mode, and emits fluorescence including a large quantity of the blue-green light component. Hence, the phosphor obtains similar function and effect to those of the Ce³⁺-activated phosphor composed by containing Lu₃(Al₁₋ₓGaₓ)₂(AlO₄)₃ as a base.

In this embodiment, a specific example of the preferable second phosphor 2A is a garnet phosphor composed by containing, as a base Lu₂CaMg₂(SiO₄)₃ that is a silicate compound. The Ce³⁺-activated phosphor composed by containing Lu₂CaMg₂(SiO₄)₃ as a base is a garnet phosphor, which emits orange light containing a large quantity of a red light component, and has relatively small temperature quenching. Thus, a high-efficiency and high-reliability light emitting device, which emits the output light 4 containing a large quantity of the red light component essential for use in illumination, is formed.

Moreover, the garnet phosphor composed by containing Lu₂CaMg₂(SiO₄)₃ as a base is a phosphor containing a large quantity of an orange light component having a substantially complementary-color relationship to the blue-green. Hence, the garnet phosphor is combined with the first phosphor 1A that emits blue-green light, and particularly with the Ce³⁺-activated phosphor composed by containing Lu₃(Al₁₋ₓGaₓ)₂(AlO₄)₃ as a base, whereby a light emitting device is formed, which achieves high efficiency and high reliability and is also easy to obtain the white-series output light 4.

"One composed by containing Lu₂CaMg₂(SiO₄)₃ as a base" refers to a solid solution in which a solid solution ratio of Lu₂CaMg₂(SiO₄)₃ is 70 mol% or more, and particularly 90 mol% or more, or refers to Lu₂CaMg₂(SiO₄)₃ as a compound. Note that, as a specific example of the solid solution in which a solid solution ratio of Lu₂CaMg₂(SiO₄)₃ is 70 mol% or more, a solid solution of Lu₂CaMg₂(SiO₄)₃ and Lu₃Al₂(AlO₄)₃ is mentioned.

In this embodiment, both of the first wavelength converter 1 and the second wavelength converter 2 can be disposed to contact each other as illustrated in FIG. 1 and FIG. 2, and can be disposed to spatially separate from each other as illustrated in FIG. 3. When both are disposed to contact each other, a compact light emitting device can be formed, and when both are disposed to spatially separate from each other, a light emitting device that controls a color tone relatively easily can be formed. Note that FIG. 3 is an example of a structure in which a translucent member 6 having translucency is disposed between both.

In this embodiment, it is preferable that the light emitting device emit the output light 4 including the light component of the excitation light 3, the light component of the first fluorescence 31, and the light component of the second fluorescence 32. Thus, a light emitting device is formed, in which it is easy to obtain the output light 4 formed by the additive color mixture of the light component of the excitation light 3, the light component of the first fluorescence 31, and the light component of the second fluorescence 32, and particularly, the white-series output light 4.

Note that preferable output light in this embodiment is white light in which a correlated color temperature is 2500 K or more and less than 8000 K, and particularly 2800 K or more and 6700 K or less. Thus, a light emitting device is formed, which emits white light and is demanded much for illumination.

Note that the average color rendering index Ra of the output light preferably exceeds 80, and is more preferably 85 or more, particularly preferably 90 or more. Thus, a light emitting device is formed, which emits white light having high color rendering properties and is demanded much for illumination.

A preferable light emitting device in this embodiment is a light emitting device configured for use in illumination or for use in display, whereby a light emitting device demanded much is formed.

Preferable ones as specific examples of the light emitting device of this embodiment are a semiconductor light emitting device, an illumination light source, an illuminator, a display device and the like, each of which is configured by using the phosphors, and particularly, are laser illumination. Then, preferably, the light emitting device of this embodiment further includes a solid-state light emitting element that emits short wavelength visible light. Use of the solid-state light emitting element as the excitation source makes it possible to achieve an all-solid-state light emitting device resistant to impact, for example, solid-state illumination.

A particularly preferable light emitting device is a light emitting device for use in any of outdoor illumination, store illumination, a dimming system, facility illumination, ocean illumination, and an endoscope.

### EXAMPLES

Hereinafter, Example of this embodiment will be described. As Example, the reflective light emitting device illustrated in FIG. 3 was prepared in consideration of easiness to create the light emitting device and easiness to evaluate light emission characteristics. Note that, with regard to the transmissive light emitting device illustrated in FIG. 1 and the light emitting device illustrated in FIG. 2, it is obvious in principle that similar function and effect to those of the reflective light emitting device prepared as Example are obtained, and this fact is naturally understandable by those skilled in the art, and accordingly, a description thereof is omitted.

As the first phosphor 1A that emits the first fluorescence 31, prepared was a Lu₃Ga₂(AlO₄)₃:Ce³⁺ phosphor (fluorescence peak wavelength of powder phosphor: 510 nm; average particle size thereof: 21 µm). Moreover, as the second phosphor 2A that emits the second fluorescence 32 different in color tone from the first fluorescence 31, prepared was a Lu₂CaMg₂(SiO₄)₃:Ce³⁺ phosphor (fluorescence peak wavelength of powder phosphor: 600 nm; average particle size thereof: 12 µm).

The Lu₃Ga₂(AlO₄)₃:Ce³⁺ phosphor was acquired from a phosphor producer. The Lu₂CaMg₂(SiO₄)₃:Ce³⁺ phosphor was prepared by thermally reacting, at a temperature of 1300 to 1400°C, mixed powder of a raw material of oxide ceramics and a compound functioning as a reaction accelerator.

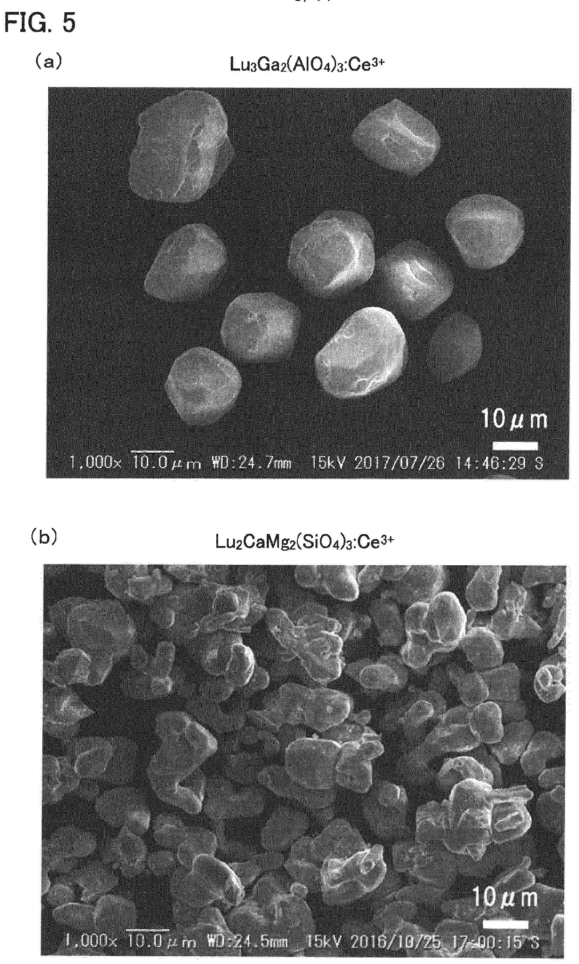

For reference, in FIG. 5(a) and FIG. 5(b), electron micrographs of the Lu₃Ga₂(AlO₄)₃:Ce³⁺ phosphor and the Lu₂CaMg₂(SiO₄)₃:Ce³⁺ phosphor according to Example are illustrated, respectively. Moreover, in Table 1, characteristics of these phosphors are summarized.

**[Table 1]**

| | | |
|---|---|---|
| Phosphor | Lu₃Ga₂(AlO₄)₃:Ce³⁺ | Lu₂CaMg₂(SiO₄)₃:Ce³⁺ |
| Composition | (Lu_{0.98}Ce_{0.02})₃Ga₂(AlO₄)₃^{*1} | (Lu_{0.97}Ce_{0.03})₂CaMg₂(SiO₄)₃ |
| Type | Aluminate | Silicate |
| Crystal Structure | Garnet Type | Garnet Type |
| Average Particle Size | 21 µm | 12 µm |
| Fluorescence Peak Wavelength | 510 nm | 600 nm |
| Internal Quantum Efficiency @ 455 nm | 90% | 72% |
| Light Absorption Rate @ 455 nm | 64% | 71% |
| *1: Estimated Composition | | |

Note that each of average particle sizes shown in Table 1 is one in which an average value of major axis lengths of fifty particles is obtained, the fifty particles being recognizable as primary particles in each of electron microscopy observation images (magnification: 1000 times) shown in FIG. 5, and being randomly picked up therefrom.

Moreover, each of the fluorescence peak wavelengths shown in Table 1 is a fluorescence peak wavelength of the powder phosphor. Note that the fluorescence peak wavelength of the powder phosphor was evaluated by a photoluminescence method of applying blue monochromatic light (spectrum half width: 4 nm) with a wavelength of 455 nm to a powder compact of the powder phosphor.

Such phosphors as described above were prepared as the phosphors which constitute the wavelength conversion member 100 of this Example. Hereinafter, a creation procedure of the wavelength conversion member 100 will be described.

First, powdery Lu₂CaMg₂(SiO₄)₃:Ce³⁺ phosphor (second phosphor 2A) was loaded into a sample holder with a diameter of 10 mm and a depth of 2 mm, and was pressed and solidified by a quartz glass plate, whereby the second wavelength converter 2 having property of a powder compact was created.

The above-described quartz glass plate was set to also serve as the translucent member 6. On the quartz glass plate, a powdery Lu₃Ga₂(AlO₄)₃:Ce³⁺ phosphor (first phosphor 1A) was arranged and fixed by using a translucent resin adhesive so that phosphor particles thereof became thin. In such a way, the first wavelength converter 1 having a dispersed state in which the particles are not in contact with one another was created.

In such a way, the wavelength conversion member 100 was obtained, in which the first wavelength converter 1 having a structure in which the phosphor particles of the first phosphor 1A were dispersed and the second wavelength converter 2 composed by including the phosphor particles of the second phosphor 2A had a stacked structure. Note that the wavelength conversion member 100 according to this Example has a structure, in which the first wavelength converter 1 and the second wavelength converter 2 are disposed to spatially separate from each other, and in which the translucent member 6 is provided between both.

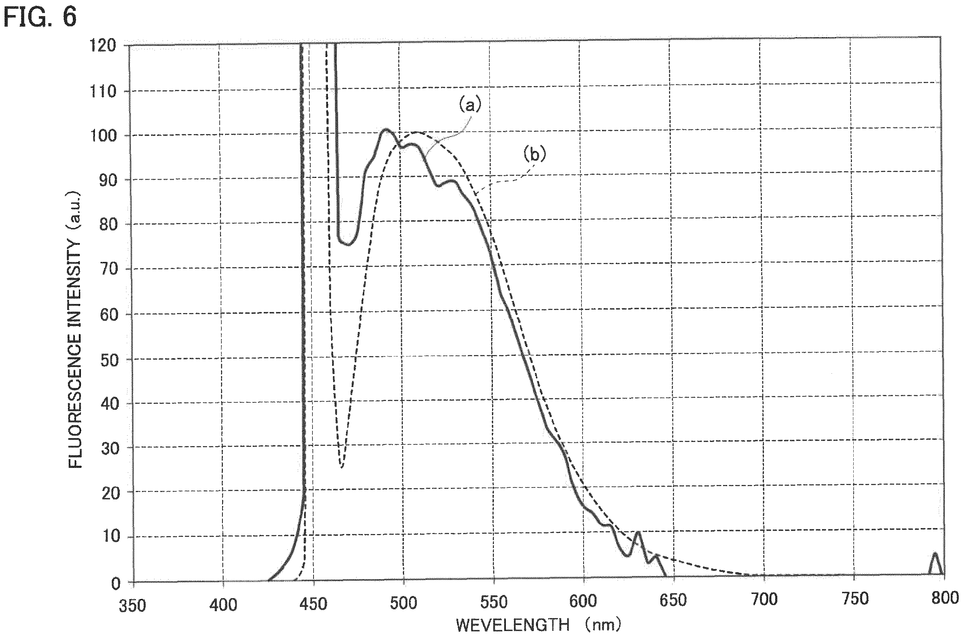

Just for reference, in FIG. 6, a fluorescence spectrum of fluorescence emitted by the first wavelength converter 1 when the above-described blue light with a wavelength of 455 nm was applied thereto is illustrated ((a) in FIG. 6). For comparison, in FIG. 6, a fluorescence spectrum of fluorescence emitted by a powder compact that was an aggregate of the first phosphor 1A when the same blue light was applied thereto is also illustrated ((b) in FIG. 6). The fluorescence spectrum of such an aggregate of the phosphor particles is evaluated as a fluorescence spectrum of that phosphor in a usual photoluminescence evaluation method.

In comparison with the fluorescence spectrum (FIG. 6(b)) of the aggregate of the phosphor particles, the fluorescence spectrum (FIG. 6(a)) of the first wavelength converter 1 according to this embodiment in which the phosphor particles are dispersed has a spectrum shape that shifts to the short wavelength side by approximately 20 nm. Then, for example, while the fluorescence peak wavelength in the florescence of the aggregate of the phosphor particles is 510 nm, the fluorescence peak wavelength in the fluorescence of the first wavelength converter 1 according to Example is 490 nm.

As described above, in accordance with this embodiment, just an arrangement of the phosphor particles of the first phosphor 1A that emits the blue-green to green fluorescence, the arrangement being performed so that the phosphor particles become thin, makes it possible to relieve the self-absorption effect of the Ce³⁺-activated phosphor. That is, even if the composition of the first phosphor 1A is not changed, the ratio of the blue-green light component of the emitted phosphor can be increased.

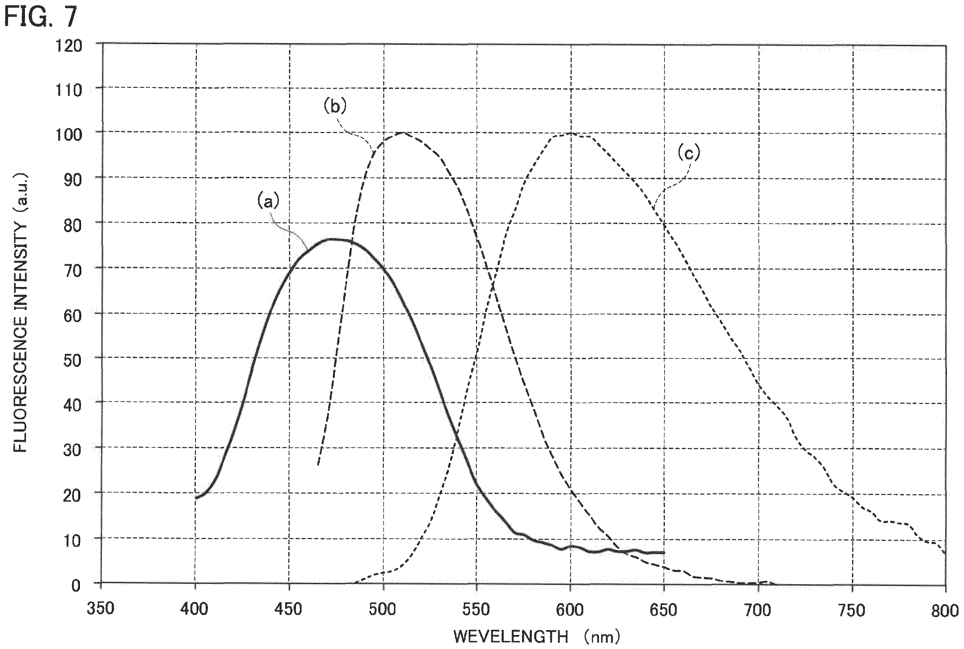

FIG. 7(a) is an excitation spectrum that represents wavelength dependency of a light absorption rate of the Lu₂CaMg₂(SiO₄)₃:Ce³⁺ phosphor. For reference, in FIG. 7(b) and FIG. 7(c), fluorescence spectra of the Lu₃Ga₂(AlO₄)₃:Ce³⁺ phosphor and the Lu₂CaMg₂(SiO₄)₃:Ce³⁺ phosphor are illustrated, respectively.

As seen from comparison between FIG. 7(a) and FIG. 7(b), the excitation spectrum of the Lu₂CaMg₂(SiO₄)₃:Ce³⁺ phosphor partially overlaps the fluorescence spectrum of the Lu₃Ga₂(AlO₄)₃:Ce³⁺ phosphor. Then, the Lu₂CaMg₂(SiO₄)₃:Ce³⁺ phosphor has a property to sufficiently absorb the short wavelength-side fluorescent component of the Lu₃Ga₂(AlO₄)₃:Ce⁺ phosphor, and particularly, a blue-green light component, and to perform wavelength conversion for the absorbed blue-green light component into orange light having a fluorescence peak at a wavelength of 600 nm. Therefore, when the Lu₃Ga₂(AlO₄)₃:Ce³⁺ phosphor and the Lu₂CaMg₂(SiO₄)₃:Ce³⁺ phosphor are brought close to each other, there occurs not a little problem that the short wavelength-side light component (blue-green light component) of the fluorescence emitted by the former one is absorbed by the latter one to decrease an intensity thereof.

In this Example, in order to suppress such a problem, the wavelength conversion member 100 is formed into the two-layer structure of the first wavelength converter 1 and the second wavelength converter 2. Then, the wavelength conversion member 100 is formed into a structure in which the first wavelength converter 1 including the Lu₃Ga₂(AlO₄)₃:Ce³⁺ phosphor forms the light output surface. Thus, the probability at which the blue-green light component of the fluorescence emitted by the first wavelength converter 1 is absorbed by the second phosphor decreases. Accordingly, the fluorescence emitted by the first wavelength converter 1 obtains a shape close to the fluorescence spectrum original to the first phosphor, and the intensity of the blue-green light component can be suppressed from decreasing.

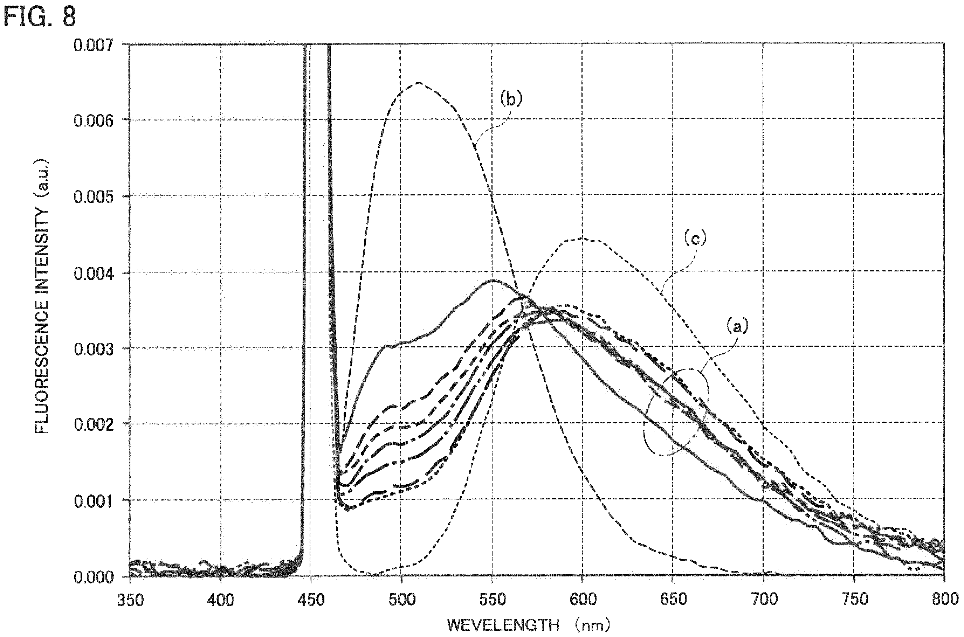

The (a) of FIG. 8 is fluorescence spectra obtained when the blue monochromatic light with a wavelength of 455 nm is applied to seven types of the wavelength conversion members 100 according to this Example, which were created while changing the dispersed state of the powdery Lu₃Ga₂(AlO₄)₃:Ce³⁺ phosphor (first phosphor 1A). For reference, in FIG. 8(b) and FIG. 8(c), fluorescence spectra of aggregates of the phosphor particles of the Lu₃Ga₂(AlO₄)₃:Ce³⁺ phosphor (first phosphor 1A) and the Lu₂CaMg₂(SiO₄)₃:Ce³⁺ phosphor (second phosphor 2A) are illustrated, respectively.

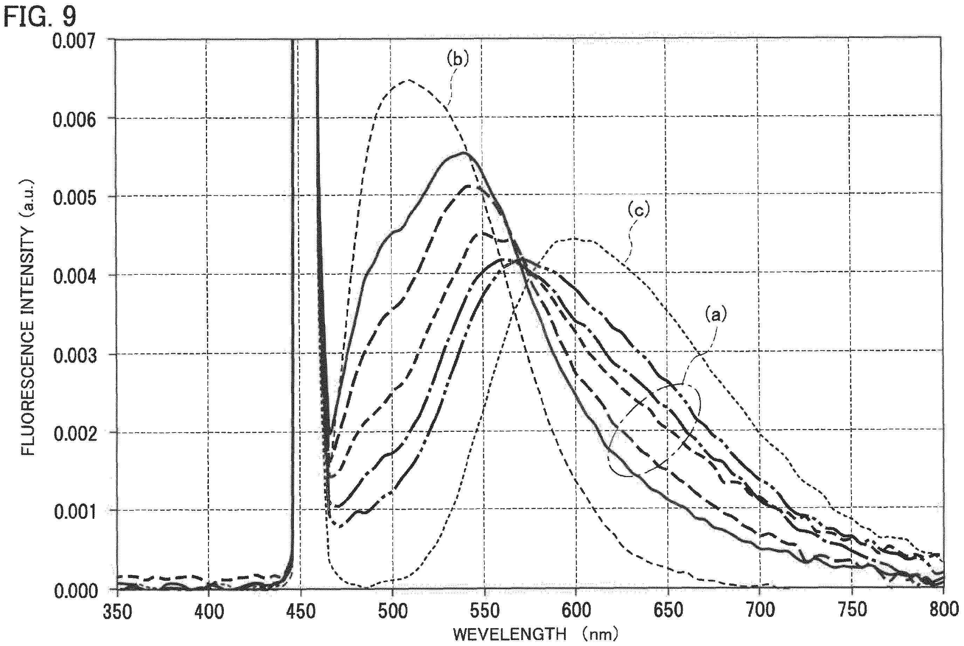

Moreover, as Comparative example, the first phosphor 1A and the second phosphor 2A were mixed with each other in different weight ratios, and five types of wavelength conversion members composed of aggregates (powder compacts) of the mixed phosphor particle were created. Such mixing weight ratios were set to 95: 5, 90: 10, 80: 20, 70: 30, and 60: 40. Spectra of fluorescences obtained when the blue monochromatic light with a wavelength of 455 nm was applied to the wavelength conversion members of this Comparative example are illustrated in (a) of FIG. 9. For reference, like FIG. 8, in FIG. 9(b) and FIG. 9(c), fluorescence spectra of aggregates of the phosphor particles of the Lu₃Ga₂(AlO₄)₃:Ce³⁺ phosphor (first phosphor 1A) and the Lu₂CaMg₂(SiO₄)₃:Ce³⁺ phosphor (second phosphor 2A) are illustrated, respectively.

As seen from comparison between FIG. 8(a) and FIG. 9(a), the fluorescence spectra of the wavelength conversion members according to this Example became those in each of which the intensity of the blue-green light component with a wavelength range of 460 to 500 nm was relatively large in comparison with that of each of the wavelength conversion members obtained by simply mixing the first phosphor and the second phosphor with each other.

Hereinafter, Example of a light emitting device including the wavelength conversion member 100 created as described above will be described.

The light emitting device of this Example is composed by combining at least the above-described wavelength conversion member 100 according to this Example and the excitation source with each other. In this Example, the light emitting device was configured in such a manner that a basic structure was formed, in which a laser diode (LD) that emits the blue light with a wavelength of 455 nm was used as the excitation source, and in which the laser diode was disposed so that the blue light was applied to the wavelength conversion member 100. Then, when such an irradiated surface of the wavelength conversion member 100 irradiated with the blue laser light was visually observed, white-series output light was recognized.

Herein, characteristics of the output light of the light emitting device according to this Example, the output light serving as illumination light, can be evaluated accurately by simulation of additively mixing the spectral distribution of the laser light and the fluorescence spectra (measured data) emitted by the wavelength conversion member 100 according to this Example, the fluorescence spectra being illustrated in FIG. 8, with each other. Accordingly, the illumination light was evaluated by simulation in order to save labor for trial production of the device and spectrum measurement of the output light, and to efficiently describe the effects of this embodiment.

Specifically, by the additive color mixture of blue laser light and each of the fluorescence spectra emitted by the wavelength conversion member 100 according to this Example, a spectral distribution of white light located on a locus of blackbody radiation was simulated, and an average color rendering index Ra was calculated from the spectral distribution. Note that the spectral distribution obtained by such simulation can be achieved by applying the techniques and knowledge about optical design, which are owned by those skilled in the art, to the light emitting device having the above-described basic structure.

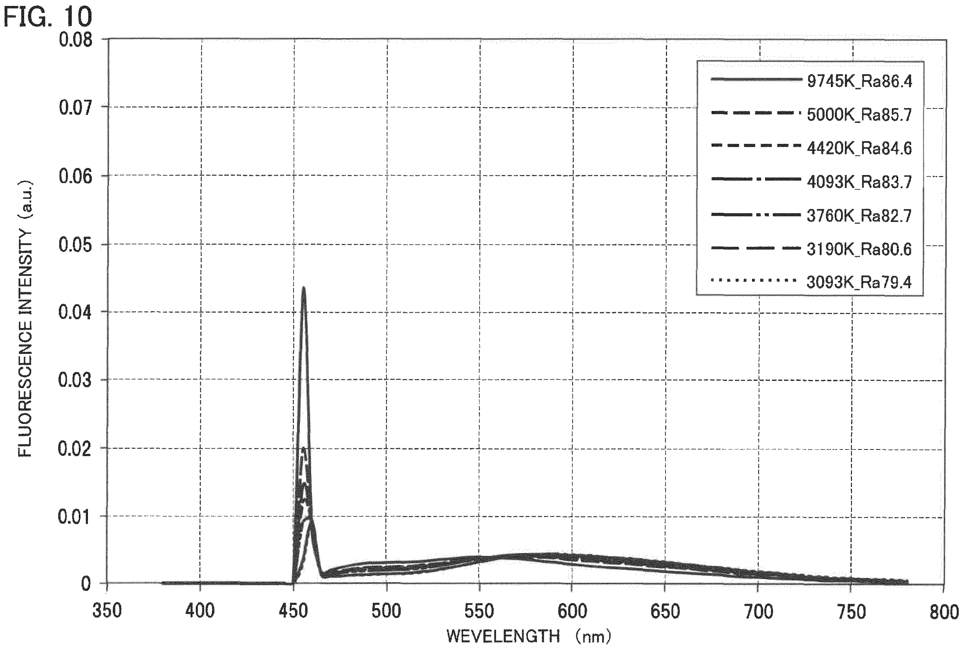

FIG. 10 is results of the above-described simulation, illustrating white light spectral distributions located on the blackbody locus (where duv = 0), which were obtained by additive color mixture of the fluorescences emitted by the seven types of wavelength conversion members according to this Example, the fluorescences being illustrated in FIG. 8(a), and of the blue laser light with a wavelength of 455 nm. Then, combinations of correlated color temperatures and average color rendering indices Ra, which were calculated from the seven types of spectral distributions illustrated in FIG. 10 became as follows. Correlated color temperature: 9745 K - Ra: 86.4. Correlated color temperature: 5000 K - Ra: 85.7. Correlated color temperature: 4420 K - Ra: 84.6. Correlated color temperature: 4093 K - Ra: 83.7. Correlated color temperature: 3760 K - Ra: 82.7. Correlated color temperature: 3190 K - Ra: 80.6. Correlated color temperature: 3093 K - Ra: 79.4.

This result indicates that the light emitting device of this embodiment can emit, as the output light 4, white light with a correlated color temperature of 3000 K or more and less than 10000 K. Then, the result indicates that illumination light with high color rendering properties in which Ra is 80 or more is obtained in a case of white light in which the correlated color temperature of the output light is 3100 K or more and less than 10000 K. Moreover, the result indicates that illumination light with higher color rendering properties in which Ra is 85 or more is obtained in a case of white light in which the correlated color temperature is 4500 K or more and less than 10000. It is seen that, as described above, the light emitting device of this embodiment becomes useful in order to obtain laser illumination with high color rendering properties by using blue laser light.

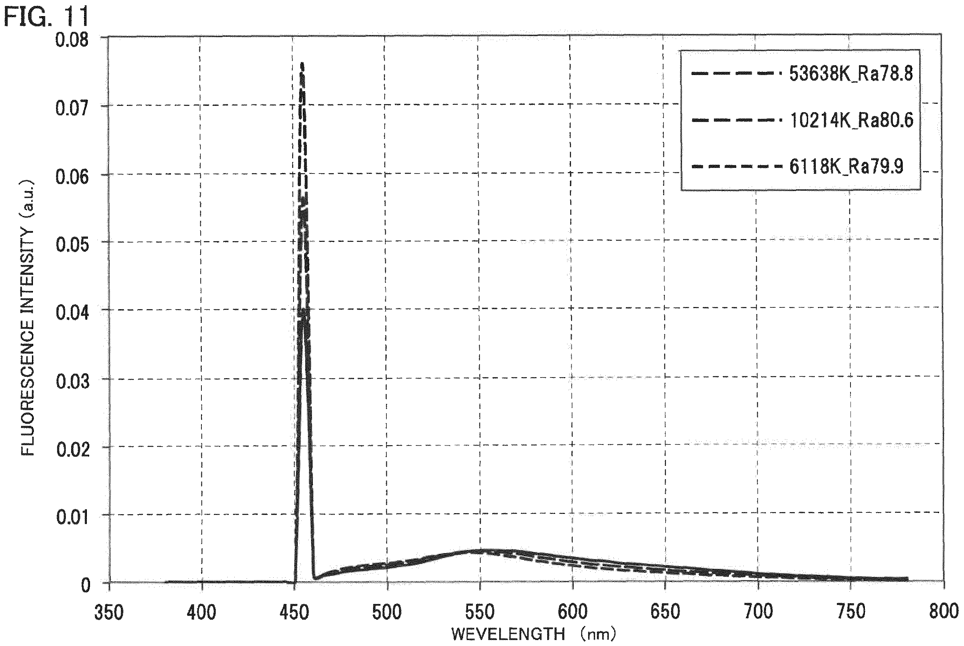

For reference, in FIG. 11, spectral distributions of Comparative examples, which were obtained by similar simulation, are illustrated. FIG. 11 is spectral distributions of white light located on the blackbody locus, the white light being obtained by additive color mixture of fluorescences from wavelength conversion members obtained by simply mixing the first phosphor and the second phosphor with each other, the fluorescences being illustrated in FIG. 9(a), and of the blue laser light with a wavelength of 455 nm. Note that, in simulation using two types of spectral distributions in which the green light component is relatively large among five types of the spectral distributions illustrated in FIG. 9(a), the ratio of the red light component was small, and white light was not able to be obtained.

Then, combinations of correlated color temperatures and average color rendering indices Ra, which were calculated from three types of the spectral distributions illustrated in FIG. 11 became as follows. Correlated color temperature: 53638 K - Ra: 78.8. Correlated color temperature: 10214 K - Ra: 80.6. Correlated color temperature: 6118 K - Ra: 79.9.

This result indicates that the light emitting device of Comparative example can emit, as the output light 4, white light with a correlated color temperature of 6000 K or more and less than 54000 K. Then, the result indicates that illumination light with Ra of approximately 80 is obtained in a case of white light in which the correlated color temperature of the output light is approximately 10000 K. However, meanwhile, the result indicates that it is difficult to obtain illumination light in which a correlated color temperature is as low as less than 5000 K and illumination light in which color rendering properties are as high as 82 or more as Ra. It is seen that, as described above, in the light emitting device of Comparative example, it is obviously difficult to obtain laser illumination with high color rendering properties by using blue laser light.

The entire contents of Japanese Patent Application No. 2017-163575 (filed on: August 28, 2017) are incorporated herein by reference.

Although the contents of this embodiment have been described above in accordance with the examples, it is obvious to those skilled in the art that this embodiment is not limited to the description of these and that various modifications and improvements are possible.

### INDUSTRIAL APPLICABILITY

In accordance with the present disclosure, there can be provided a light emitting device including a plurality of types of Ce³⁺-activated phosphors different in color tone and an excitation source, wherein, even in a case of adopting a device structure in which a warm color-series phosphor and a green-series phosphor are close to each other, a light component intensity of blue-green light is relatively large and color rendering properties of output light are high.

### REFERENCE SIGNS LIST

- 1: first wavelength converter
- 1A: first phosphor
- 2: second wavelength converter
- 3: excitation light
- 4: output light
- 5: sealing material
- 6: translucent member
- 31: first fluorescence
- 32: second fluorescence
- 100: Wavelength conversion member

## Claims

1. A light emitting device comprising:
a solid-state light emitting element that emits excitation light having a maximum intensity value within a wavelength range of 440 nm or more and less than 470 nm; and
a wavelength conversion member composed by combining a first wavelength converter, which includes a first phosphor that is a particulate phosphor and is an inorganic phosphor activated by Ce³⁺, and a second wavelength converter, which includes a second phosphor that is an inorganic phosphor activated by Ce³⁺, with each other,
wherein the first phosphor emits first fluorescence having a maximum intensity value within a wavelength range of 470 nm or more and less than 530 nm, and the second phosphor emits second fluorescence having a maximum intensity value within a wavelength range of 580 nm or more and less than 660 nm, and
the first wavelength converter has a dispersed state in which particles of the first phosphor are not in contact with one another.

2. The light emitting device according to claim 1,
wherein the second phosphor is a particulate phosphor, and
the second wavelength converter has a contact structure in which particles of the second phosphor are in contact with one another.

3. The light emitting device according to claim 1 or 2, wherein the second wavelength converter is a sintered body that is composed by sintering the second phosphor and has a plurality of air gaps in an inside, or ceramics that is composed by sintering the second phosphor and does not have a plurality of air gaps in an inside.

4. The light emitting device according to any one of claims 1 to 3, wherein the excitation light enters the wavelength conversion member so as to directly irradiate the second wavelength converter, and a light component transmitting through the wavelength conversion member is output as output light.

5. The light emitting device according to any one of claims 1 to 3, wherein the excitation light enters the wavelength conversion member so as to directly irradiate the first wavelength converter, and a light component reflected by the wavelength conversion member is output as output light.

6. The light emitting device according to any one of claims 1 to 5, wherein the first phosphor is at least one of aluminate and silicate.

7. The light emitting device according to any one of claims 1 to 6, wherein the second phosphor is at least one of silicate and aluminosilicate.

8. The light emitting device according to claim 6, wherein the first phosphor is aluminate having a garnet-type crystal structure.

9. The light emitting device according to claim 7, wherein the second phosphor is silicate having a garnet-type crystal structure.
